Europäisches Patentamt

European Patent Office

Office européen des brevets

(11) Publication number: **0 316 951**
**A1**

## (12) EUROPEAN PATENT·APPLICATION

(21) Application number: **88119242.1**

(22) Date of filing: **18.11.88**

(51) Int. Cl.⁴: **H01L 29/36 , H01L 29/08 , H01L 29/72**

(30) Priority: **20.11.87 JP 293313/87**

(43) Date of publication of application:
**24.05.89 Bulletin 89/21**

(84) Designated Contracting States:
**DE FR GB**

(71) Applicant: **NEC CORPORATION**
**33-1, Shiba 5-chome, Minato-ku**
**Tokyo 108(JP)**

(72) Inventor: **Kurosawa, Susumu**
**c/o NEC Corporation 33-1, Shiba 5-chome**
**Minato-ku Tokyo(JP)**
Inventor: **Shiba, Hiroshi**
**c/o NEC Corporation 33-1, Shiba 5-chome**
**Minato-ku Tokyo(JP)**

(74) Representative: **Glawe, Delfs, Moll & Partner**
**Patentanwälte**
**Postfach 26 01 62 Liebherrstrasse 20**
**D-8000 München 26(DE)**

(54) A transistor having a low impurity-concentration base.

(57) There is disclosed a transistor composed of an emitter region of first conductivity type, a collector region of the first conductivity type and a base region of second conductivity type positioned between the emitter and collector regions, the peak value of the impurity concentration of the base region being between $2 \times 10^{16}$ cm$^{-3}$ and $1 \times 10^{17}$ cm$^{-3}$.

FIG.2

EP 0 316 951 A1

# A TRANSISTOR HAVING A LOW IMPURITY-CONCENTRATION BASE

## BACKGROUND OF THE INVENTION

### Field of Industrial Application

The present invention. relates to a transistor suitable for a super LSI and operable at a high speed.

### Description of the Related Art

Bipolar transistors have been widely used in many semiconductor circuits. Especially, in logic circuits and memories, the bipolar transistors were used for improving the operation speed of these circuits. The conventional bipolar transistors neither operate at high speed for a low operating current nor perform a saturation operation at high speed. Therefore, further improvement of high speed operation cannot be expected, unless the structure of bipolar transistors are reformed. ·

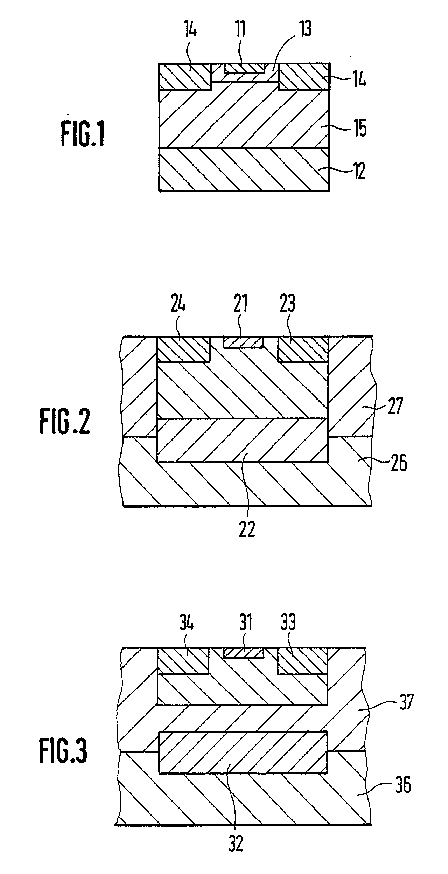

More specifically, the principal structure of the bipolar transistor in the prior art are shown in Fig. 1. An NPN transistor is formed on a $N^+$-type region 12 which acts as a part of a collector region and which is a burried region formed between a semiconductor substrate and an epitaxial layer in a semiconductor integrated circuit. An N-type collector region 15 is foemed on the $N^+$-type region 12. A P-type base region 13 and at least one $P^+$-type base contact region 14 are formed in the N-type collector region 15 by impurity diffusion or implantation. An $N^+$-type emitter region 11 are then formed in the P-type base region 13.

The $N^+$-type region 12 of the high impurity concentration is used for reducing the collector resistance. The substantial collector operations are accomplished by the collector region 15 of the low impurity concentration. This substantial collector region 15 is made to have the low impurity concentration so as to raise the withstand voltage.

The impurity concentration of the base region 13 is set at a far higher level than the low impurity concentration of the collector region 15 so that most of the depletion layer at the base-collector junction may extend in the low-concentration collector region 15. As a result, the actual base width (i.e., the thickness of the electrically neutral region) is substantially equal to the interval between the emitter region 11 and the collector region 15, i.e., the metallurgical width. This actual width and the impurity concentration of the base region are very important factors for the performances of the transistor. For a higher speed, the actual width of the base region is reduced, and the impurity concentration is accordingly increased. At present, in the transistor directed to the high-speed operations, the actual thickness of the base region is set at about 0.1 μm, and the peak value of the impurity concentration is no less than $1 \times 10^{18}$ cm$^{-3}$.

However, the above-specified bipolar transistor in the prior art has the emitter region 11 and base region 13 made very shallow for the high-speed operations and its actual base region between the emitter region 11 and the collector region 15 narrowed to make a narrow base width. As a result, the transistor is liable to have its electric characteristics influenced by the change in its fabrication process and its emitter-collector shorted even with a slight crystal defect.

On the other hand, an integrated circuit using the bipolar transistor is also required to have a high speed operation in a low current range or a complementary structure to save power consumption for a super-high integration. However, the bipolar transistor in the prior art cannot operate at a high speed within the low current range although it can operate at the high speed within a high current range. Moreover, the small base width makes it very difficult to fabricate an NPN transistor and a PNP transistor concurrently in a single semiconductor chip by using N- and P-type impurities of different diffusion coefficients, because the re-diffusions of the impurities cannot be sufficiently controlled.

In the bipolar transistor, moreover, the base-collector junction to be intrinsically used in the backward bias state may come into the forward bias state (which will be called the "saturated state") in the circuit operations. In order to release this saturated state, the positive holes injected into the base region in the case of the NPN transistor, for example, have to be extracted through the base electrode. The time required for the extractions is called the "storage time", which is too long in the bipolar transistor in the prior art to perform the saturated operations at the high speed. In order to suppress the high saturation, the base-collector junction has to be clamped by the use of a Schottky diode or the like.

There have also been reported several transistors, in which the thickness and impurity concentration of the base region are set to establish a completely depleted state in the base region so that the collector current may be controlled by the potential barrier established in the base region. These transistors are intended to reduce the actual base width and the junction capacity. These transistors are: the static induction transistor (SIT) reported by Jun-ichi Nishizawa as "Analysis of Static Characteristics of a Bipolar-Mode SIT (BSIT)" on pp. 1233 to 1244 of "IEEE Transactions on Electron Devices", August Edition of 1982 (ED-29, 8th Edition); the transistor having its base region substantially pinched off, as proposed by R. Zuleeg in U.S.P. No. 3,409,812; and the bulk-barrier transistor reported by H. Mader et al., as "Bulk-Barrier Transistor" on pp. 1380 to 1386 of "IEEE Transactions of on Electron Devices", October Edition of 1983 (ED-30, 10th Edition).

Those reported transistor such as the BSIT or the bulk-barrier transistor having its base region completely depleted is accompnaied, when used in an integrated circuit, by the following many problems that its electric characteristics seriously fluctuate with the change in the fabrication conditions, that the current-voltage characteristics cannot work other than of the unsaturated type, and that the pattern shape of its base electrode is restricted.

## SUMMARY OF THE INVENTION

It is, therefore, an object of the present invention to provide a novel transistor which can operate at a high speed within a low current range, perform a saturation operation at a high speed, have high current amplification factors in both forward and backward direction, be relatively freed from to have its electric characteristics influenced by the fabrication conditions, be fabricated with a high yield and be easily integrated.

According to the present invention, there is provided a transistor which comprises: emitter and collector regions of first conductivity type; and a base region of second conductivity type positioned between those emitter and collector regions, wherein the impurity concentration of the base region has a peak value between $2 \times 10^{16}$ cm$^{-3}$ and $1 \times 10^{17}$ cm$^{-3}$ and is no more than $1 \times 10^{17}$ cm$^{-3}$.

Since the impurity concentration of the base region is kept small to have at most $1 \times 10^{17}$ cm$^{-3}$, the effective value of the carrier mobility is high with a small junction capacity. The width of the metallurgical base region may be made large enough for the electric characteristics to be less influenced by the manufacturing conditions. Furthermore, since re-diffusion of the impurity once difficed will hardly change the electric characteristics due to the wide base region, the complementary types of our inventive transistors can be easily formed in a single semiconductor chip. Still furthermore, since the actual base width is determined by interval between depletion layers extending from the base-emitter and base-collector junctions, the actual base width can be made extremely thin to exhibit a superior high-frequency characteristics.

## BRIEF DESCRIPTION OF THE DRAWINGS

The above and further objects, features and advantages of the present invention will become more apparent from the following detailed description taken in conjunction with the accompanying drawings, wherein:

Fig. 1 is a section showing a bipolar transistor in the prior art;

Fig. 2 is a section showing a transistor according to a first embodiment of the present invention;

Fig. 3 is a section showing a transistor according to a second embodiment of the present invention;

Fig. 4 is a graph presenting one example of the dependency between the base electrode gap of the cut-off current and the peak value of the base impurity concentration;

Fig. 5 is a graph presenting one example of the dependency between the peak value of the cut-off frequency $f_T$ and the peak value of the base impurity concentration;

Fig. 6 is an impurity concentration distribution diagram presenting the impurity distribution in the depthwise direction just below the emitter of the transistor according to the first embodiment of the present invention;

Figs. 7(a), 7(b) and 7(c) are distribution diagrams showing the potential distribution, electron concentration distribution and positive hole concentration distribution in the depthwise direction just below the emitter of the transistor according to the first embodiment of the present invention;

Fig. 8 is a graph presenting the current-voltage characteristics of the transistor according to the first embodiment of the present invention;

Fig. 9 is a graph presenting the characteristics of the DC current amplification factor $h_{FE}$ of the transistor according to the first embodiment of the present invention;

Fig. 10 is a graph presenting the $f_T$ characteristics of the transistor according to the first embodiment of the present invention;

Fig. 11 is a circuit diagram showing the current change-over type switch circuit; and

Fig. 12 is a section showing a third embodiment of the present invention, in which the circuit of Fig. 11 is integrated by the transistors of the present invention.

## DESCRIPTION OF THE PREFERRED EMBODI-
## MENTS

The present invention will be described in the following with reference to the accompanying drawings. Incidentally, the description to be made is directed for conveniences to the case of an NPN transistor.

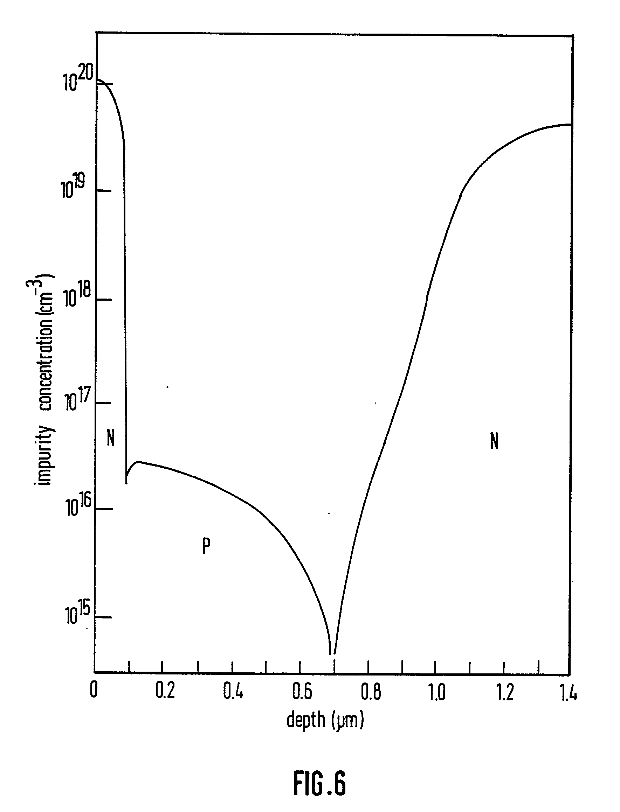

Fig. 2 is a section showing the first embodiment of the present invention. The transistor is formed in a semiconductor integrated circuit and is formed in an N-type silicon epitaxial layer 27 on a P-type silicon substrate 26. At the interface between the epitaxial layer 27 and the substrate 26, an N-type buried region 22 is formed with a peak impurity concentration of $6 \times 10^{19}$ cm$^{-3}$. The impurity concentration distribution of the buried region 22 in the depth direction is shown in Fig. 6. A P-type base region 23 is formed on the buried region 22 by implanting impurities into the epitaxial layer 27 so as to reach the buried region 22. The impurity profile in the base region 23 is also shown in Fig. 6. It has a peak value of $3 \times 10^{16}$ cm$^{-3}$ which is selected from a range between $2 \times 10^{16}$ cm$^{-3}$ and $10 \times 10^{16}$ cm$^{-3}$ so as not to come into a completely depleted condition during the transistor action. The metallurgical width of the base region 23 is 0.7 $\mu$m. An N$^+$-type emitter region 21 is formed in the base region 23 with a depth of 0.1 $\mu$m and an impurity concentration of $10^{20}$ cm$^{-3}$ which is selected from a value of impurity concentration larger than $1 \times 10^{19}$ cm$^{-3}$. Two base contact regions 24 are formed in the base region 23 to interpose the emitter region 21, with an N-type impurity concentration larger than $10^{19}$ cm$^{-3}$ or $10^{20}$ cm$^{-3}$, for example, for ensuring an ohmic contact of wiring layer (not shown in Fig. 2) to the base region 23.

The operational principle of the transistor of the present embodiment is substantially similar to those of the conventional bipolar transistor. The difference resides in the impurity concentration and apparent base width of the base region 3. The impurity concentration of the base region 3 is set at a value either between $2 \times 10^{16}$ cm$^{-3}$ and $1 \times 10^{17}$ cm$^{-3}$ or lower than the specified value so that the mobility of the carrier is high with a low junction capacity. Moreover, the apparent base width is 0.6 $\mu$m or selected from a range between 0.3 $\mu$m and 1.0 $\mu$m and is large enough for the electric characteristics to be less influenced by the fabrication conditions. The collector-emitter junction is hardly shorted to enhance the manufacturing yield. The re-diffusion of the impurity in the collector region 22 during the emitter diffusion process or other impurity diffusion process will hardly change the electric characteristics so that the complementary structure can be easily realized. Moreover, the actual base width is determined at a sufficiently small value by the depletion layer extending from P-N junctions with the emitter region 1 and the collector region 2 so that high-frequency characteristics of high performance can be extracted.

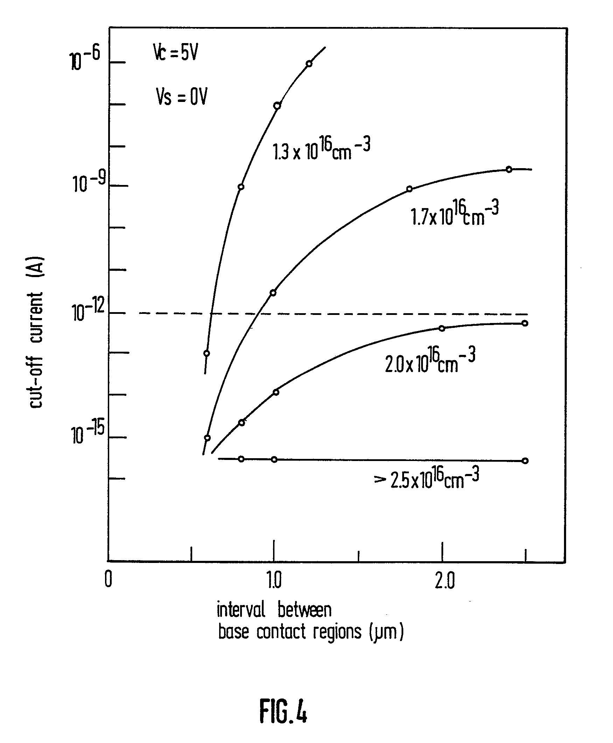

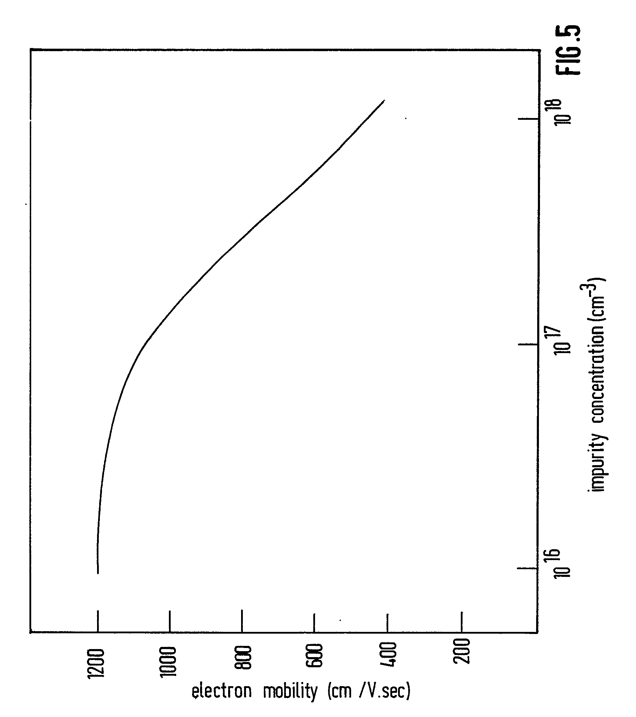

Since the metallurgical base width (i.e., the thickness of the P-type base region 23) and the actual base width (i.e., the width between the depletion layers extending from the two P-N junctions with the emitter and collector regions 21 and 22) are different, there exists a large degree of freedom in setting the impurity distribution of the base region 23. In a case where the base region 23 is to be formed by the ion implantation, the impurity distribution of the base region 23 can be designed depending upon the dosage and energy of the ion implantation and the temperature and the processing time of the subsequent heat treatment. If, however, the dosage of the ion implantation is too low, the transistor does not comes into the current cut-off state, because the depletion layers from the emitter and collector regions 21 and 22 are contact to each other. Fig. 4 shows this behavior exemplifying the dependency of the gap between the two base contact regions 24 of the cut-off collector current and the peak value of the base impurity concentration when the collector voltage $V_C$ = 5 V and the base voltage $V_B$ = 0 V are applied. In Fig. 4, the cut-off current region below the broken line indicates the region in the cut-off state. In case, however, the peak value of the base impurity concentration is low, the current cut-off characteristics highly depend upon the base electrode gap and the peak value of the base impurity concentration. In a case where this peak value of the base impurity concentration is no more than $2 \times 10^{16}$ cm$^{-3}$, the base region 3 comes into a completely depleted state but not the current cut-off stage. If the peak value of the base impurity concentration is set at a value no less than $2 \times 10^{16}$ cm$^{-3}$, the depletion regions in the base region 23 from the emitter and collector regions 21 and 22 do not come into contact to each other to provide excellent current cut-off characteristics independent of the gap between the base contact regions 24. In order to ensure the cut-off state reliably within the operational range, the peak value of the impurity concentration required is no less than $2 \times 10^{16}$ cm$^{-3}$. If, on the other hand, the peak value of the base impurity concentration is too high, the electron mobility drops to degrade the high-frequency characteristics. This behavior is illustrated in Fig. 5. If the peak value of the base impurity concentration is more than $10^{17}$ cm$^{-3}$, as shown, the electron mobility will abruptly drop. For high-speed operations, therefore, it is necessary to set the peak value of the impurity concentration at a value less

than $10^{17}$ cm$^{-3}$. The profile of the impurity concentration of the NPN transistor thus obtained in the depthwise direction just below the emitter region 21 is illustrated in Fig. 6.

Since the base region 23 is metallurgical thick, i.e., since the base region between the emitter-base junction and the base-collector junction is thick, the electric characteristics of the transistor are hardly influenced by the fabrication conditions, and the emitter and the collector are very hardly shorted by the crystal defect or the like. Because of the high degree of freedom for setting the impurity concentration distribution of the base region 3, moreover, the NPN transistor and the PNP transistor using N- and P-type impurities of different diffusion coefficients can be fabricated concurrently on the same chip and with high performances.

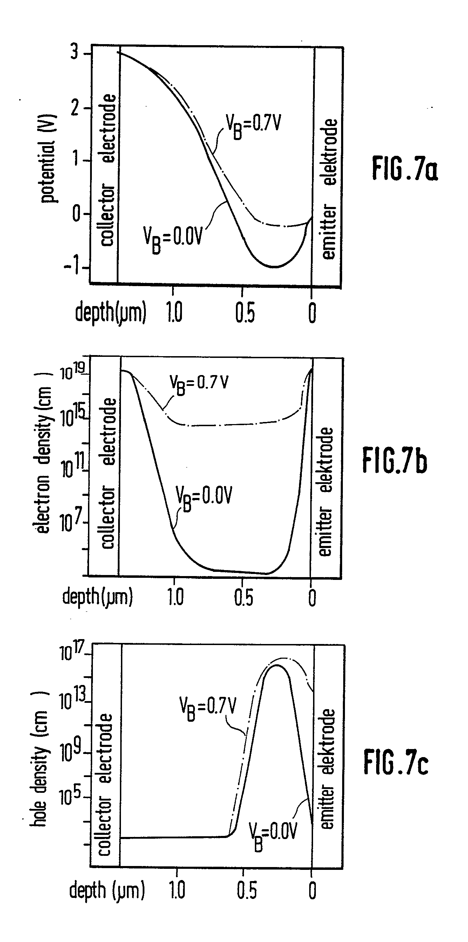

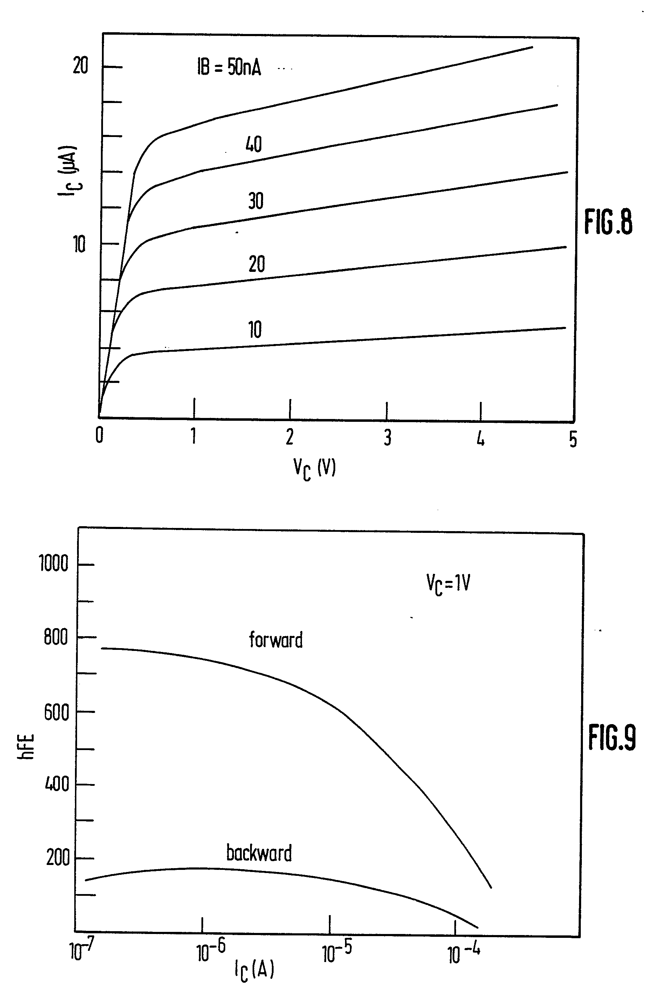

Figs. 7(a) to 7(c) present analytical examples of the potential distribution, electron concentration distribution and positive hole concentration distribution in the depthwise direction just below the emitter region 1 of the transistor having the impurity concentration distribution illustrated in Fig. 6. These analyses were accomplished at a collector voltage $V_C$ = 3 V and base potentials $V_B$ = 0.0 V and 0.7 V. It is found from the potential distribution that the depletion layer extends from the emitter and collector to the base region 23. It is also found from the positive hole concentration distribution that base region 3 does not comes into the completely depleted state and that the actual base width is reduced to 0.1 to 0.2 $\mu$m. Fig. 8 illustrates the current-voltage characteristics of a transistor having an emitter size of 1.2 $\mu$m x 1.2 $\mu$m. There are illustrated the saturated-type characteristics, which are apparently different from those of the transistor having its base region in the completely depleted state. Fig. 9 illustrates one example of the characteristics of a DC current amplification factor $h_{FE}$. This amplification factor to be obtained can be easily as high as several handreds because the impurity concentration of the base region 23 is low in the forward operations. In the backward operations, too, it is easy to obtain a value no less than 100.

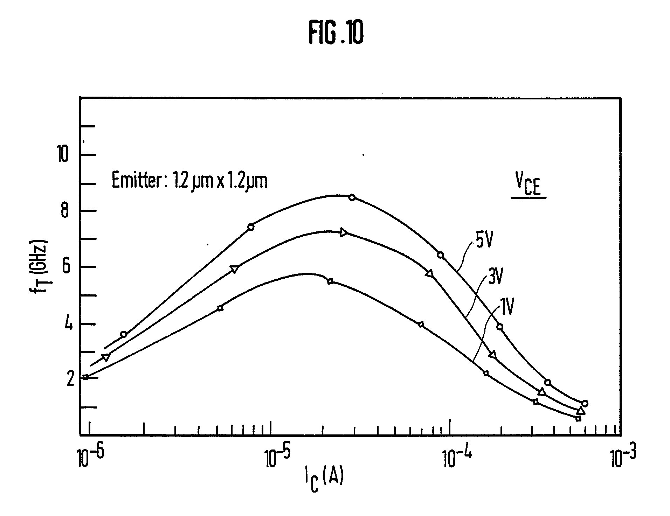

Fig. 10 illustrates one example of the $I_C$-$f_T$ characteristics of the transistor having an emitter size of 1.2 $\mu$m x 1.2 $\mu$m. Because of the low impurity concentration of the base region 23, the emitter-base junction capacity and the base-collector junction capacity can be made small so that the rise of $f_T$ is excellent in a low-current range. Because of the low impurity concentration of the base region 23, moreover, the mobility of the carriers is several times as high as that of the bipolar transistor in the prior art so that the peak value of the $f_T$ is considerably high. As a result, the high speed can be realized in the low-current range.

In the saturated state in which the base-collector junction is biased forward, on the other hand, the low impurity concentration of the base region 23 reduces the number of positive holes to be injected into the collector and shortens the storage time.

Fig. 2 shows the structure in which two base contact regions 24 are formed at both sides of the emitter region 21. In the transistor of the present invention, however, the positions of the base contact regions 24 relative to the emitter region 21 and the pattern shape in top plan view may be arbitrary, because the non-depleted region of the base region 23 just below the emitter region 21 is directly biased through the base electrodes contacted to the base contact regions 24, similarly to the bipolar transistor in the prior art. In order to reduce the base resistance, it is desired that the base contact regions 24 may be positioned either at the two sides of or to enclose the emitter region 21 so that they may be as close to each other as possible to raise no problem in their junction withstand voltage.

Although the foregoing description has been directed to the case of the NPN transistor, the present invention may be applied to another type transistor such as a PNP transistor or a heterogeneous junction transistor and can easily realize the multi-emitter structure. In Fig. 2, on the other hand, the portions 21 and 22 belong to the emitter region and the collector region, respectively, but vice versa.

Furthermore, the transistor of the kind shown in Fig. 2 may be directly formed on a silicon substrate of N$^+$-type by directly forming the base region 23 on the silicon substrate. The base region 23 to be directly formed on the silicon substrate may be formed as an epitaxial layer having a uniform impurity concentration or an impurity implanted region into an epitaxial layer. Any base region should have a peak impurity concentration of 2 x $10^{16}$ cm$^{-3}$ to 10 x $10^{16}$ cm$^{-3}$. The N$^+$-type substrate should have an impurity concentration higher than the base region at the interface between the base region.

Fig. 3 is a section showing the second embodiment. The transistor is also formed in a semiconductor integrated circuit having a P-type silicon substrate 36. An N-type expitaxial layer 37 is grown on the substrate 36 with an impurity concentration of 1 x $10^{15}$ cm$^{-3}$ to 1 x $10^{16}$ cm$^{-3}$ and a thickness of 1.2 $\mu$m. At the interface between the substrate 36 and the epitaxial layer 37, an N$^+$-type buried region 32 is formed to have a peak impurity concentration of 6 x $10^{19}$ cm$^{-3}$. A base region 33 is formed by implanting impurity ions into the epitaxial layer 37 to have a peak impurity concentration of 3 x $10^{16}$ and a depth of 0.7 $\mu$m. As a result of the base region formation, the epitaxial layer 37 remains between the base and buried regions 33 and 32 with a thickness of 0.5 $\mu$m. An $N^+$-type emitter region 31 is formed in the surface region of the base region 33 with an impurity concentration of 1 x $10^{20}$ cm$^{-3}$ and a thickness of 0.1 $\mu$m. Two base contact regions 34 are also formed in the surface region of the base region 33 with an impurity concentration of 1 x $10^{20}$ cm$^{-3}$ and a thickness of 0.3 $\mu$m so as to interpose the emitter region 31.

The operation of the transistor shown in Fig. 3 is similar to that of Fig. 2. The buried region 32, however, operates to decrease the collector resistance. Actual collector function operates with the epitaxial layer 37 between the base and buried regions 33 and 32. For the collector function according to the present invention, the impurity concentration of the epitaxial layer 37 is so set that depletion layer may sufficiently extend into the base region 33 in the operational condition. That is, it is better to make the impurity concentration of the epitaxial layer 37 higher than the base region 33 at the junction with the base region 33. The impurity concentration of the epitaxial layer 37 may, however, have a value lower than the base region 33 at the junction with the base region 33, if the thickness of the epitaxial layer 37 between the base region 33 and the buried region 32 is so thin that the depletion layer may extend into the base region with the aid of the high impurity concentration of the buried region 32. Furthermore, for obtaining a high withstand voltage, the impurity concentration of the epitaxial layer 37 should have as low as possible. In this embodiment, it is selected to have an impurity concentration of 1 x $10^{15}$ cm$^{-3}$ to 1 x $10^{16}$ cm$^{-3}$. The transistor according to the second embodiment shown in Fig. 3 can operate at higher voltage region than that shown in Fig. 2.

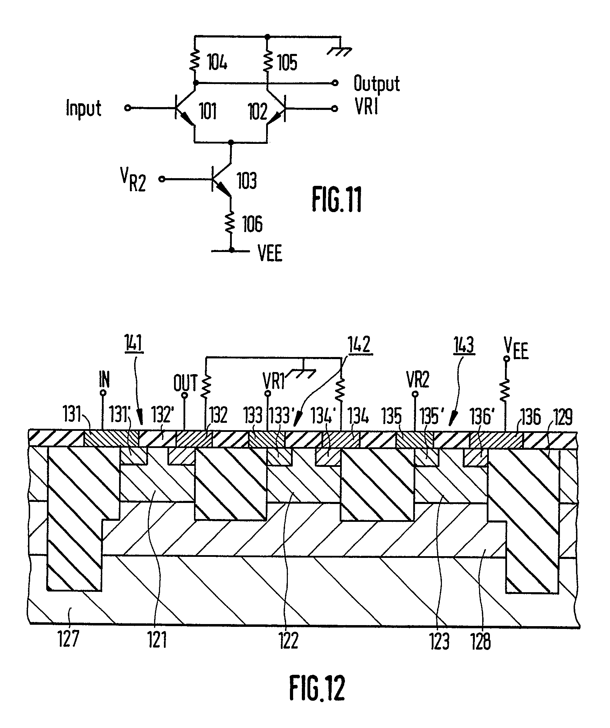

Figs. 11 and 12 are a circuit diagram for explaining the third embodiment of the present invention applied to an integrated circuit and a section showing the structure of the integrated circuit device. The circuit shown in Fig. 11 is a well-known current change-over type switch. As shown, the current to be changed is supplied from a constant current source composed of a transistor 103 and a resistor 106. The constant current is switched in response to an input signal applied to the input terminal by a change-over switch composed of transistors 101 and 102. Collectors of those switching transistors 101 and 102 are connected to load resistors 104 and 105. The switched current is extracted from the output terminal in a form of voltage.

The structure of this integrated circuit is shown in section in Fig. 12. As shown, the transistors 101, 102 and 103 correspond to transistors 141, 142 and 143, respectively, and are formed on a P-type silicon substrate 127. An $N^+$-type region 128 of high impurity concentration is a buried region having a thickness of 0.2 $\mu$m and having its sides separated by electric insulation substrates 129 such as $SiO_2$ and is shared commonly as the emitter regions of the transistors 141 and 142 and the collector region of the transistor 143. These transistors have their respective base regions composed of P-type regions 121, 122 and 123 which are formed by implanting ions into a silicon epitaxial layer grown over the N-type region 128 on the substrate 127. The P-type regions 121, 122 and 123 are separated by the electric insulation substances 129 such as $SiO_2$. The base electrodes are led out through P-type polycrystalline silicon thin films 131, 133 and 135 connected to $P^+$-type base contact regions 131$'$, 133$'$ and 135$'$ of high impurity concentration connected with those thin films. The collector regions of the transistors 141 and 142 and the emitter region of the transistor 143 are composed of $N^+$-type regions 132$'$, 134$'$ and 136$'$ of high impurity concentration, and the corresponding electrodes are led out to the surface of the substrate though N-type polycrystalline silicon thin films 132, 134 and 136 connected with those N-type regions. The electrodes thus led out to the substrate surface are connected with resistors by the well-known integration method, thus completing the device.

The most important point disclosed in this third embodiment is to clarify the method of integrating the transistor according to the present invention in the most preferable state. Sine the transistor according to the present invention can achieve a high current amplification factor in both the forward and backward direction, as has been described hereinbefore, erect and inverted types can be arbitrarily combined for the integration. Thus, the connections of the elements can be partially accomplished by the continuous buried region 128 without using wiring layer to reduce the wiring area so that the integration density can be drasitcally improved. Thanks to the adoption of the inverted transistor, the collector terminal is cut off from the parasitic capacity accompanying the separation so that the performance can be remarkably improved together with the low power consumption and high speed operability of the transistor itself.

The present embodiment is directed to an example, in which the three transistors 103, 101 and 102 are confined in one island separated from other region enclosed by the deep electric insulation substance 129 by making the transistor 103 of erect type and the transistors 101 and 102 of inverted type and in which the parasitic capacity is eliminated from the collector terminal having a large voltage amplitude.

As has been described hereinbefore, according to the present invention, it is possible to obtain the high speed operability, the high $h_{FE}$ and the short storage time in the low-current range of the transistor. By enlarging the metallurgical base width, moreover, it is possible to easily achieve the high yield and the simultaneous fabrication of complementary types of transistors on a single chip. On the other hand, the actual base width can be reduced by the depeletion layers extending from the emitter and the collector to extract the high performance. As a result, the present invention can achieve the super high integration and the super high speediness at the same time so that it can enjoy a remarkably high effect.

**Claims**

1. A transistor comprising: an emitter region of first conductivity type; a collector region of said first conductivity type; and a base region of second conductivity type positioned between said emitter region and said collector region, wherein the impurity concentration of said base region has a peak value between $2 \times 10^{16}$ cm$^{-3}$ to $1 \times 10^{17}$ cm$^{-3}$ and is no more than said peak value.

2. A transistor as claimed in claim 1, wherein said base region has a thickness between 0.3 $\mu$m to 1.0 $\mu$m.

3. A transistor as claimed in claim 2, wherein said collector region has such an impurity concentration that the depletion layer generated at the P-N junction between said base and collector regions may extend in said base region.

4. A transistor as claimed in claim 2, wherein said base region has a base contact region of said second conductivity type, said base contact region having portions interposing said emitter region in plan view at the surface of said base region, and said base contact region having an impurity concentration larger than $1 \times 10^{19}$ cm$^{-3}$.

5. A transistor as claimed in claim 4, wherein said base contact region has two separated portions interposing said emitter region.

6. A transistor as claimed in claim 3, wherein said collector region has a first layer of low impurity concentration contacting said base region and a second layer of high impurity concentration contacting with said first layer on a side opposite to said base region, the impurity concentration and the thickness of said first region being designed so as to extend the depletion layer to said base region from said collector region.

7. A transistor as claimed in claim 6, wherein said impurity concentration of said first layer is higher than said base region at a portion of said base region contacting said collector region.

FIG.1

FIG.2

FIG.3

FIG.4

FIG.5

EP 0 316 951 A1

FIG.6

FIG.7a

FIG.7b

FIG.7c

FIG.8

FIG.9

# FIG.10

Input ○——|⊲ 101    102 ⊳|—— Output
                                    VRl

104    105

$V_{R2}$ ○——|⊲ 103

106

VEE

## FIG.11

141    142    143    V_EE

IN    OUT    VRI    VR2

131  131'  132'  132  133  133'  134'  134  135  135'  136'  136  129

127    121    122    123    128

## FIG.12

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | EP-A-0 216 380 (TOSHIBA K.K.)<br>* Column 2, lines 33-48; column 4, lines 23-32; figure 2 * | 1 | H 01 L 29/36<br>H 01 L 29/08<br>H 01 L 29/72 |
| Y | | 2,3,6,7 | |
| A | | 4,5 | |
| Y | FR-A-2 301 922 (SIEMENS)<br>* Page 4, lines 2-16; figure 4 * | 2,3 | |
| Y | IBM TECHNICAL DISCLOSURE BULLETIN, vol. 20, no. 11A, April 1978, pages 4452-4453, New York, US; M. BRISKA et al.: "Producing a transistor with an optimal concentration profile"<br>* Whole article * | 6,7 | |
| A | US-A-4 178 190 (POLINSKY)<br>* Abstract; column 6, lines 10-14; figures 9,10 * | 1,4-5 | |
| A | PATENT ABSTRACTS OF JAPAN, vol. 5, no. 179 (E-82)[851], 17th November 1981; & JP-A-56 107 580 (FUJITSU K.K.) 26-08-1981<br>* Abstract * | 1,4,5 | **TECHNICAL FIELDS SEARCHED (Int. Cl.4)**<br><br>H 01 L |

The present search report has been drawn up for all claims

| Place of search | Date of completion of the search | Examiner |
|---|---|---|
| THE HAGUE | 23-02-1989 | HARRISON R.J. |

EPO FORM 1503 03.82 (P0401)